# EUROPÄISCHE PATENTANMELDUNG

(11) **EP 2 174 785 A2**
(43) Veröffentlichungstag der Anmeldung: **14.04.2010**
(21) Anmeldenummer: 09170270.4
(22) Anmeldetag: 15.09.2009
(51) Int. Cl.: B41C 1/00

(54) **Verfahren und Vorrichtung zur Vermeidung von Moirées bei Bebilderung von Substraten**

(30) Priorität: 10.10.2008 DE 102008050928
(71) Anmelder: Heidelberger Druckmaschinen AG, 69115 Heidelberg (DE)
(72) Erfinder: Zelenka, Thomas, Dr., 24248 Mönkeberg (DE)

(57) **Zusammenfassung**

Bei der Bebilderung einer Druckplatte (3) auf einer Belichtertrommel (2) mittels Lasermodule (7), welche eine Vielzahl von Laserstrahlen (9) auf die Oberfläche der Druckplatte (3) emittieren, kann es aufgrund der Raster der einzelnen Laserdioden eines Lasermoduls (7) und der Raster einer in einem RIP (13) gerasterten Druckvorlage leicht zu einem Moirée kommen, wenn die Abstände der Laserdioden eines Lasermoduls (7) nicht vollständig gleichförmig sind.

Um die Ausbildung solch eines Moirées wenigstens zu verringern ist es erfindungsgemäß vorgesehen, dass beim Bebildern einer Druckplatte (3) Pixel auf der Oberfläche der Druckplatte (3) von den Laserstrahlen (9) so belichtet werden, dass der Rasterfrequenz des Rasters (100) gemäß der Druckvorlage eine höhere Ortsfrequenz überlagert wird, so dass ein variabler tatsächlicher Abstand der belichteten Pixel auf der Oberfläche der Druckplatte (3) entsteht. Auf diese Weise wird das Ortsraster der Laserdioden eines Lasermoduls (7) insoweit manipuliert, dass keine Periodizität mehr vorhanden ist, welche die Bildung eines Moirées unterstützt.

## Beschreibung

Die vorliegende Erfindung betrifft ein Verfahren zum Bebildern eines Substrates mittels einer Mehrzahl von Bebilderungselementen, wobei die Bebilderungselemente im Wesentlichen in periodischen Abständen zueinander bereitgestellt werden und Bebilderungsemissionen auf die Oberfläche des Substrates in Abhängigkeit von Bilddaten emittieren und die Bebilderungsemissionen ein Rastermuster mit Rasterfrequenz auf dem Substrat ergeben.

Des Weiteren betrifft die Erfindung eine Vorrichtung zur Bebilderung eines Substrates mittels Bebilderungsemissionen, umfassend Bebilderungselemente zur Emission der Bebilderungsemissionen und erste Bewegungselemente zur relativen Bewegung der Bebilderungselemente und des Substrates zueinander.

In der Reproduktionstechnik werden Druckvorlagen für Druckseiten erzeugt, die alle zu druckenden Elemente wie Texte, Grafiken und Bilder enthalten. Für den farbigen Druck wird für jede Druckfarbe eine separate Druckvorlage erzeugt, die alle Elemente enthält, die in der jeweiligen Farbe gedruckt werden. Für den Vierfarbdruck sind das die Druckfarben Cyan, Magenta, Gelb und Schwarz (CMYK). Die nach Druckfarben separierten Druckvorlagen werden auch Farbauszüge genannt. Die Druckvorlagen werden in der Regel gerastert und mit einem Belichter auf Filme belichtet, mit denen dann Druckplatten für das Drucken hoher Auflagen hergestellt werden. Alternativ können die Druckvorlagen in speziellen Belichtungsgeräten auch gleich auf Druckplatten belichtet werden oder sie werden direkt als digitale Daten an eine digitale Druckmaschine übergeben. Dort werden die Druckvorlagendaten dann beispielsweise mit einer in die Druckmaschine integrierten Belichtungseinheit auf Druckplatten belichtet, bevor unmittelbar anschließend der Auflagendruck beginnt.

Nach dem heutigen Stand der Technik werden die Druckvorlagen elektronisch reproduziert. Dabei werden Bilder in einem Farbscanner gescannt und in Form von digitalen Daten gespeichert oder liegen gleich als digitale Daten vor. Texte werden mit Textverarbeitungsprogrammen erzeugt und Grafiken mit Zeichenprogrammen. Mit einem Layoutprogramm werden die Bild-, Text- und Grafik-Elemente zu einer Druckseite zusammengestellt. Die Daten mehrerer Druckseiten werden mit den Daten weiterer Elemente, wie Passkreuzen, Schnittmarken und Falzmarken sowie Druckkontrollfeldern, zu Druckvorlagen für einen Druckbogen zusammengefasst. Als Datenformate zur Beschreibung der Druckvorlagen werden heute weitgehend die Seitenbeschreibungssprachen Postscript und PDF (Portable Document Format) verwendet. Die Postscript- bzw. PDF-Daten werden vor der Aufzeichnung der Druckvorlagen in einem Raster-Image-Prozessor (RIP) in die gerasterten Farbauszüge CMYK umgerechnet.

In den Aufzeichnungsgeräten, die zur Belichtung von Druckvorlagen und Druckformen eingesetzt werden, wird beispielsweise ein Laserstrahl von einer Laserdiode erzeugt, durch optische Mittel geformt und auf das Aufzeichnungsmaterial fokussiert und mittels eines Ablenksystems Punkt- und Linienweise über das Aufzeichnungsmaterial abgelenkt. Es gibt auch Aufzeichnungsgeräte, die zur Erhöhung der Belichtungsgeschwindigkeit ein oder mehrere Bündel von Laserstrahlen erzeugen, z.B. mit einem bzw. mehreren Laserdiodenarrays, und mit jedem Überstreichen des Aufzeichnungsmaterials mehrere Bildlinien der Druckform gleichzeitig belichten. Das Aufzeichnungsmaterial kann sich auf einer Trommel befinden (Außentrommelbelichter), in einer zylindrischen Mulde (Innentrommelbelichter) oder auf einer ebenen Fläche (Flachbettbelichter). Bei einem Außentrommelbelichter wird das zu belichtende Material in Form von Filmen oder Druckplatten auf eine drehbar gelagerte Trommel montiert. Während die Trommel rotiert, wird ein Belichtungskopf in einem relativ kurzen Abstand axial an der Trommel entlang bewegt. Der Belichtungskopf fokussiert einen oder mehrere Laserstrahlen auf die Trommeloberfläche, die die Trommeloberfläche in Form einer engen Schraubenlinie überstreichen.

Eine entsprechende Beschreibung zum Aufbau eines Trommelbelichters, insbesondere des Aufbaus eines Trägers für entsprechende Laserdioden zur Bebilderung der Druckplatten ist in der europäischen Patentanmeldung EP 1454743 A2 gegeben, auf die hiermit entsprechend Bezug genommen wird.

Weitere Vorrichtungen und Verfahren mit denen Druckplatten, Filme oder auch direkt Papier, Pappe oder ähnliches als Bedruckstoff bebildert werden können sind beispielsweise elektrofotographische Verfahren wie die Xerographie, Inkjet-Verfahren sowohl in der Art eines Continuons-Inkjets oder eines tropfenweisen Inkjets, als auch direkt die thermische Bebilderung von Druckplatten innerhalb einer Druckmaschine oder indirekte Verfahren bei denen mittels Bebilderungselementen wie Laserdioden eine vorhandene Fototrommel positiv oder negativ bebildert wird.

Bei all diesen Verfahren können die Inkjet-Tropfen der Inkjet-Strahl oder entsprechende Laserstrahlen von Laserdioden als Bebilderungsemission direkt auf ein Substrat wie einen Bedruckstoff oder eine Druckplatte, ein Film oder eine Folie emittiert werden oder durch zusätzliche Ablenkvorrichtungen wie akustooptische Modulatoren oder Kondensatoren zum Ablenken von Inkjet-Tropfen nach der Emission dieser Bebilderungsemissionen abgelenkt werden.

Die einzelnen Bebilderungselemente, die Laserdioden oder Inkjet-Öffnungen können dabei in Reihen in Form von Arrays, insbesondere von Arrays mit nur einer Reihe angeordnet sein. Gemäß des Herstellungsprozesses von Inkjet-Köpfen oder Laserdiodenarrays sind diese mit einer vorgegebenen Weite zueinander beabstandet, dem sogenannten Pitch.

Die Bilddaten, die der Bebilderung des Substrates zugrunde liegen, werden an die Bebilderungsköpfe in einer gerasterten Form nach einer sogenannten Rasterbitmap, welche von einem RIP auf Grundlage einer Druckvorlage erzeugt wird weitergegeben. Die Rasterpunkte der Rasterbitmap haben dabei eine exakt vorgegebene Rasterfrequenz. Aufgrund der elektronischen Erzeugung der Rasterbitmap sind hierbei Abweichungen der Rasterfrequenz nicht gegeben. Bei der Anordnung der Bebilderungselemente auf dem Träger bzw. innerhalb des Arrays kann es aber aufgrund des Herstellungsverfahrens zu Abweichungen des Pitches benachbarter Bebilderungselemente kommen. Da es sich bei den tatsächlich belichteten Pixeln, d. h. Bildelementen auf dem Substrat um eine Überlagerung des Pitches der Bebilderungselemente und des vorgegebenen Rasters aus der Rasterbitmap handelt, kann es durch kleine Abweichungen des Abstandes der Bebilderungselemente zueinander zu einer Moiréebildung im fertigen Druckbild auf dem Substrat kommen.

Die vorliegende Erfindung hat daher die Aufgabe, ein Verfahren und eine Vorrichtung vorzustellen, die solch eine Moiréebildung zumindest verringert.

Die Aufgabe der durch ein gattungsgemäßes Verfahren gemäß Anspruch 1 und eine gattungsgemäße Vorrichtung gemäß Anspruch 9 gelöst.

Durch die Überlagerung der Rasterfrequenz der Bildpunkte auf dem Substrat mit einer höheren Ortsfrequenz, d. h. dass die einzelnen Pixel auf dem Substrat von ihrer Position, die sie gemäß der Rasterbitmap einnehmen sollen nur leicht relativ zum Abstand der verschiedenen Pixel verschoben sind wird die Ortsfrequenz, die durch den Pitch der Bebilderungselemente, d. h. in Abstand der Bebilderungselemente zueinander vorgegeben ist bezüglich der Position der Pixel auf dem Substrat aufgehoben. Es kommt somit nicht mehr zu einer Überlagerung einer ersten Frequenz, d. h. der Rasterfrequenz und einer zweiten Frequenz gemäß der Abstände der Bebilderungselemente.

Dieses kann vorrichtungsmäßig dadurch erreicht werden, dass zusätzlich zu ersten Bewegungselementen, welche für die relative Bewegung der Bebilderungselemente und des Substrats verantwortlich ist, zweite Bewegungselemente vorgesehen sind, welche wenigstens ein Organ aus der Menge Bebilderungselement, Substrat, Basisfläche zur Bereitstellung des Substrates, Träger zur Bereitstellung wenigstens einer der Bebilderungselemente und Ablenkelemente zur Ablenkung der Bebilderungsemission vorhanden sind. Durch diese zweiten Bewegungselemente können diese entsprechenden Organe zumindest eines oder mehrere davon, relativ zueinander so bewegt werden, dass die starre Frequenz der Ortsauflösung der Bebilderungselemente bezüglich der Pixel auf dem Bedruckstoff oder auf dem Substrat aufgehoben wird.

In einer vorteilhaften Weiterentwicklung ist es vorgesehen, dass die Ortsfrequenz als solche, welches der Rasterfrequenz überlagert wird, stochastisch moduliert wird. Auf diese Weise kann sichergestellt werden, dass es auch durch ungünstige Ortsfrequenzen der Überlagerung in Bezug auf die Ortsfrequenz der Bebilderungselemente dennoch zumindest weniger Moiréeeffekte gibt.

Im Allgemeinen sind die Bebilderungselemente in Richtung einer Vorschubsrichtung der Bebilderungselemente relativ zum Substrat voneinander beabstandet. Damit die in dieser Richtung liegende Ortsfrequenz durch die Überlagerung der zweiten Bewegung aufgehoben werden kann, ist es erfindungsgemäß weiter vorgesehen, dass die Ortsfrequenz der Bebilderungsemission auf dem Substrat durch eine Relativbewegung von Substrat und Bebilderungsemissionen im Wesentlichen senkrecht zur Ausbreitungsrichtung der Bebilderungsemission moduliert wird. Dieses kann erfindungsgemäß dadurch erreicht werden, dass zur Modulation der Bebilderungsemission Ablenkelemente in die Ausbreitungsrichtung der Bebilderungselemente bereitgestellt und bewegt werden oder die Bebilderungsemission entsprechend der vorgesehenen Überlagerungen ablenken.

Alternativ kann auch vorgesehen sein, dass die Bebilderungselemente und das Substrat zur Bebilderung des Substrates mit einer ersten relativen Bewegung relativ zueinander bewegt werden und zur Modulation der relativen Positionen von Bebilderungsemission und Substrat zueinander der ersten Bewegung der Bebilderungselemente und des Substrates eine zweite Bewegung überlagert wird.

Diese Überlagerung mittels einer zweiten Bewegung kann in einer ersten Ausführungsform dadurch gewährleistet werden, dass die Bebilderungselemente wenigstens teilweise auf einem gemeinsamen Träger bereitgestellt werden und dieser Träger relativ zum Substrat in eine Vorschubsrichtung bewegt wird. Dieser Vorschubsbewegung wird dann eine Modulationsbewegung im Wesentlichen in Richtung der Vorschubsbewegung überlagert.

In einer zweiten Alternative ist es möglich, dass nicht der Träger, sondern das Substrat in die Vorschubsrichtung des Trägers gemäß der zweiten Bewegung entsprechend der gewünschten Modulation bewegt wird. Hierfür kann entweder das Substrat als solches alleine bewegt werden oder die Basisfläche selber, auf welcher sich das Substrat befindet.

Erfindungsgemäß ist es weiter vorgesehen, dass es sich bei den Bebilderungselementen um eines aus der Menge Laserdiode, Laserquelle, Inkjet-Kopf, Inkjet-Düse und Fotodiode handelt. Dieses Aufzählung soll dabei nicht endgültig sein, es handelt sich vielmehr um Beispiele, welche Bebilderungselemente beschreiben, welche zur Bebilderung von Bedruckstoffen, wie Papier, Pappe oder Druckformen wie z. B. Protoleitertrommeln, Druckplatten oder Filme geeignet sind. Es kann sich daher bei den Bebilderungsemissionen erfindungsgemäß um eines aus der Menge Laserstrahl, Lichtstrahl, Inkjet-Tropfen und Inkjet-Strahl handeln. Bei dem Substrat kann es demgemäß eines aus der Menge Bedruckstoff, Papier, Papierbahn, Papierbogen, Pappe, Folie, Film, Fotoleitertrommel und Druckplatte handeln. Für den Fall, dass Ablenkelemente vorgesehen sind, kann es sich dabei um eines aus der Menge optisches Ablenkelement, Linsen, akustooptischer Modulator und Kondensator handeln. Es soll dabei insbesondere nicht eingeschränkt werden, dass auch Bebilderungsverfahren ohne solche Ablenkelemente umfasst sind.

Vorrichtungsmäßig sind mehrere Alternativen vorgesehen, bei denen eine erste Ausführungsform, welche bevorzugt werden soll, so ausgebildet ist, dass es sich bei dem Substrat um eine Druckplatte handelt, die auf einer Trommel oder in einer Belichtungsmulde bereitgestellt ist, die Bebilderungselemente Laserdioden sind, die Laserdioden Laserstrahlen als Bebilderungsemissionen zur Bebilderung der Druckplatte emittieren und die Laserdioden wenigstens teilweise auf einem gemeinsamen Träger bereitgestellt sind, wobei die ersten Bewegungselemente in der Art einer Vorschubsspindel mit einem Vorschubsmotor bereitgestellt sind und die zweiten Bewegungselemente als Ansteuerungsorgan dem Vorschubsmotor so zugeordnet sind, dass dieser Vorschubsbewegung des Trägers eine zweite Bewegung gemäß eines Bewegungsprofils so überlagert wird, dass der Rasterfrequenz der belichteten Bildpunkte auf der Druckplatte eine zweite höhere Ortsfrequenz überlagert wird, so dass es zu kleinen Abweichungen der Positionen der Bildpunkte auf der Druckplatte kommt.

Mit kleinen Abweichung sind hier Abweichungen in einem Bereich unterhalb der Linienbreite, d. h. unterhalb des Bereiches um 10 Mikrometer handelt. Hierfür kann eine entsprechende zeitliche Modulation der Bewegung des Trägers im Kilohertzbereich bei einer Schreibgeschwindigkeit von 2 Metern pro Sekunde realisiert werden.

In einer zweiten alternativen Ausführungsform kann es vorgesehen sein, dass nicht die Laserdioden oder das Array von Laserdioden bewegt wird, gemäß der überlagerten Modulation, sondern dass hierfür die Trommel oder die Belichtungsmulde, in welcher die Druckplatte eingespannt ist, parallel zur Vorschubsrichtung so bewegt wird, dass der Rasterfrequenz der bebilderten Pixel auf der Druckplatte eine zweite höhere Ortsfrequenz überlagert wird. Auch hier können mechanische Bewegungen im Kilohertzbereich vorgesehen sein, welche die Trommel oder Belichtungsmulde im Wesentlichen parallel zur Vorschubsrichtung des Trägers schwingend antreiben. Insbesondere kann diese mechanische Schwingung im Kilohertzbereich selber stochastisch moduliert werden, so dass der genaue Frequenzbereich abgegrenzt, aber modulierbar ist.

Wie bereits oben beschreiben, kann es sich bei den Bebilderungselementen um eines aus der angegebenen Menge handeln und gleiches gilt entsprechend für das Substrat und ein gegebenenfalls vorhandenes Ablenkelement, welches aber nicht unbedingt vorhanden oder bewegbar sein muss.

Beispiele der erfindungsgemäßen Vorrichtung und des erfindungsgemäßen Verfahrens auf die die Erfindung aber nicht beschränkt sein soll und aus denen sich weitere eigenständige erfindungsgemäße Merkmale ergeben können, sind in den Zeichnungen dargestellt. Es zeigen:
- Figur 1: eine Belichtungstrommel mit zugeordneten Bebilderungselementen und
- Figur 2: ein Raster auf einem Substrat mit modulierter Ortsfrequenz.

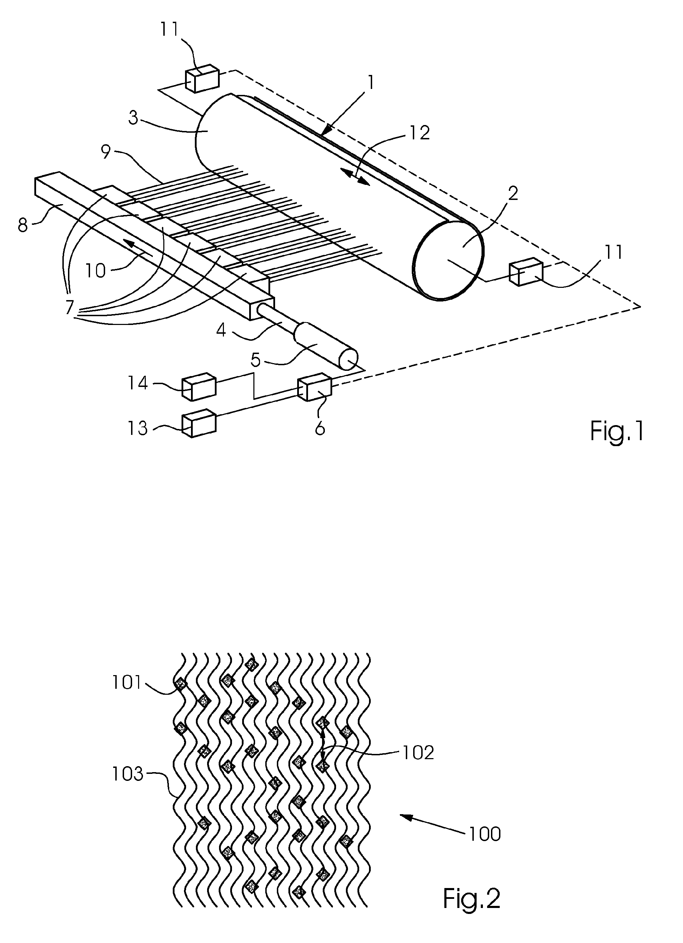

In der Figur 1 ist ein Plattenbelichter 1 skizziert. Der Plattenbelichter 1 weist eine Belichtertrommel 2 zur Aufnahme einer Druckplatte 3 auf. Die Druckplatte 3 wird mittels modulierter Laserstrahlen 9 bebildert. Die Modulation der Laserstrahlen 9 erfolgt in Abhängigkeit einer hier nicht weiter dargestellten Rasterbitmap, die als Grundlage wiederum Druckvorlagen für die Abbildung eines Vorlagebildes hat.

Die Laserstrahlen 9 werden von Laserdioden, die selber Lasermodulen 7 zugeordnet sind emittiert. Jedes Lasermodul 7 weist dabei ein Array von Laserdioden auf.

Die Lasermodule 7 sind in dem hier dargestellten Beispiel auf einem gemeinsamen Träger 8 angeordnet, welcher auf einer Vorschubspindel 4 angebracht ist, durch welche er in Vorschubsrichtung 10 entlang und parallel zur Belichtertrommel 2 bewegbar ist. Die Vorschubspindel 4 ist zum Vorschub des Trägers 8 mit einem Vorschubsmotor 5 verbunden. Des Weiteren ist hier ein Ansteuerungsorgan 6 zur Ansteuerung des Vorschubsmotors in Abhängigkeit von der gewünschten überlagerten Bewegung für den Träger 8 vorgesehen.

Jedes Lasermodul 7 emittiert eine Vielzahl von Laserstrahlen 9. Es gibt dabei mehrere Konzepte für den Aufbau solcher Arrays. Es können dabei bis zu 512 einzelne Laserdioden oder auch Laserdioden, welche Laserstrahlen emittieren, welche wiederum in einzelne Laserstrahlen 9 aufgespalten werden, umfasst sein. Beispielsweise können die Module 7 identische Arrays mit jeweils 64 in Reihe angeordneten Laserdioden aufweisen. Die Abstände zwischen den Laserdioden eines Arrays sind dabei möglichst konstant gehalten. Die Laserdioden eines Moduls 7 sind dabei in Richtung der Vorschubsrichtung 10 angeordnet. Zur Bebilderung der Druckplatte 3 wird der Träger 8 mit hoher Gleichmäßigkeit entlang der Bewegungsachse der Belichtertrommel 2 entlang bewegt, während die Belichtertrommel 2 rotiert.

Die Bebilderung der Druckplatte 3 erfolgt dabei in Abhängigkeit eines periodischen Rasters, welches zur Erzeugung der Rasterbitmap verwendet wurde. Durch die Belichtung solcher periodischer Strukturen wie des Bitmaprasters mit einem hier vorliegenden periodischen Array können Moirées leicht entstehen. Dieses Entstehen von Moirées wird insbesondere durch kleine Ungleichmäßigkeiten im Abstand der Laserdioden des Arrays zueinander unterstützt.

Auch noch so genaue Fertigungen der Lasermodule 7 können Abweichungen in der Lichtleistung, der Punktgröße und insbesondere auch der Position der einzelnen Laserdioden nicht verhindern. Im Allgemeinen liegen diese Abweichungen von der gewünschten Position im Prozentbereich, führen aber zu eine Interferenz mit der periodischen Rasterfrequenz. Diese Interferenz wird auf der belichteten Druckplatte 3 als Moirée sichtbar.

Der Vorschubsmotor 5 treibt die Module 7 wenigstens indirekt über den Träger 8 mit einer niedrigen Bewegungsgeschwindigkeit, die einer Schreibgeschwindigkeit von etwa 2 Metern pro Sekunde entspricht, an. Entsprechend der Größe des Spots der Laserstrahlen 9 und der Rotationsgeschwindigkeit der Belichtertrommel 2 in Verbindung mit der Vorschubsgeschwindigkeit der Spindel 4 ergeben sich Linienbreiten von etwa 10 Mikrometern. Immer nach dem Umlauf der Belichtertrommel 2 um eine komplette Umdrehung wird eine zweite Linie neben die erste geschrieben. Dieses erfolgt vorzugsweise nach dem sogenannten Interleaf-Verfahren, wobei eine Linie zwischen zwei schon bestehende Linien geschrieben wird.

Zur Unterdrückung des beschriebenen Moirées ist hier das Ansteuerungsorgan so ausgebildet, dass der relativen Bewegung zwischen Träger 8 und Trommel 2 in Bewegungsrichtung 10 durch den Vorschubsmotor 5 eine zweite vorgegebene schnelle Bewegung überlagert wird. Diese zweite schnelle Bewegung kann dabei insbesondere für jedes zu belichtende Raster individuell generiert oder hinterlegt sein. Die Vorgaben für die zweite Modulationsbewegung kann dabei in einem Speichermittel 14 in Form von lookuptables in Abhängigkeit von den verwendeten Rastern abgelegt sein. Über eine Verbindung zwischen dem Ansteuerungsorgan 6 und einem Rasterimageprozessor (RIP) 13 kann das Ansteuerungsorgan 6 in Abhängigkeit von dem vorliegenden Raster, d. h. in Abhängigkeit von Rasterwinkel und Rasterfrequenz das gewünschte Modulationsmuster für die zweite Bewegung auswählen. Dieses gewünschte Bewegungsprofil für den Träger 8 kann dabei zum einen experimentell in Abhängigkeit von bekannten Rastern ermittelt oder auch in Abhängigkeit von Rasterwinkel und Rasterfrequenz berechnet werden. Insbesondere kann statt eines looup-tables eine Vorschrift zur Berechnung des gewünschten Bewegungsprofils des Trägers 8 im Speicher 14 hinterlegt sein.

In der Figur 2 ist eine Skizze von einem so erzeugten Raster durch eine Überlagerung der Raster der vorgelegten Rasterbitmap mit dem entsprechenden Bewegungsprofil durch das Ansteuerungsorgan 6 skizzenhaft dargestellt. In der Praxis werden Bildpunkte einer Bildvorlage die den Druckvorlagen zugrunde liegt mittels Rasterzellen dargestellt. Diese können beispielsweise mit 16 Linien geschrieben werden, wobei die Breite der einzelnen Linien im Bereich von 10 Mikrometern liegt. Das menschliche Auge erkennt periodische Strukturen mit einer Periode von 2 bis 9 Millimeter besonders stark. Die Frequenz des überlagerten Bewegungsprofils wird daher so gewählt, dass die gemeinsame Periode aus der überlagerten Bewegungsfrequenz mit der Rasterfrequenz aus der Rasterbitmap außerhalb der Wahrnehmung des menschlichen Auges liegt. Die Amplitude der überlagerten Bewegung durch das Ansteuerungsorgan 6 soll dabei eine sehr kleine Größe annehmen, d. h. es soll eine sehr kleine Bewegungsamplitude vorliegen, die unterhalb einer Linienbreite liegt. Dadurch sind nur geringste Bewegungen bei der Ansteuerung der Spindel 4 durch den Vorschubsmotor 5 in Richtung der Vorschubsrichtung 10 und entgegengesetzt notwendig. Dieses kann durch ein entsprechendes Bewegungsprofil, welches die Bewegung der Spindel 4 kurzfristig beschleunigt und wieder abbremst erreicht werden.

Wie in der Figur 2 dargestellt kann das so erzeugte Raster 100 auf der Druckplatte 3 erreicht werden. Dieses Raster 100 ist aufgebaut aus belichteten Pixeln 101, die in ihrer Verbindung zueinander eine Rasterzelle, bestehend aus 255 Punkten, die einem Bildpunkt der Vorlage entsprechend bebildern. Die einzelnen Pixel 101 sind hier rautenförmig dargestellt. Sie entsprechen dabei den Positionen, an welchem ein Pixel belichtet oder nicht belichtet werden soll. Der Abstand 102 der Pixel 101 wird dabei durch die überlagerte Bewegung gemäß der hier skizzierten periodischen Auslenkung 103 variiert. Die periodische Auslenkung 103 wird dabei durch die mechanische, periodische Bewegung des Trägers 8 erreicht. Die wirksame Unterdrückung von Moirées ist es bereits mit Positionsabweichungen von weniger als 10 Mikrometern im Abschnitt von einigen Millimetern möglich. Dieses kann bei einer Schreibgeschwindigkeit von 2 Metern pro Sekunde durch eine mechanische Bewegung des Trägers 8 im Kilohertzbereich erreicht werden.

Wie in Figur 1 dargestellt, kann die relative Bewegung zwischen Laserdiode und Druckplatte 3 durch ein entsprechendes Beschleunigen und Abbremsen des gesamten Trägers 8 erreicht werden. Alternativ ist es aber auch möglich einzelne Arrays, d. h. einzelne Module 7 mit einem eigenständigen mechanischen Antrieb zu versehen, welcher z. B. durch Piezoelemente realisiert werden kann. Bei dieser Lösung wird eine geringere Masse bewegt und können größere Beschleunigungskräfte zum Abbremsen und Beschleunigen der einzelnen Laserstrahlen 9 in Vorschubsrichtung 10 realisiert werden. Entsprechend können die Ablenkungen der Laserstrahlen 9 in Vorschubsrichtung 10 auch durch steuerbare optische Ablenker erreicht werden. Hierbei kann es sich z. B. um akustooptische Modulatoren handeln, welche selber bewegt werden oder entsprechend eingestellt sind. Andere optische Elemente aus Linsen können auch eingesetzt werden.

In Figur 1 ist weiterhin eine weitere Ausführungsform zur relativen Bewegung zwischen Druckplatte 3 und Träger 8 dargestellt, welche nicht nur alternativ, sondern auch zusätzlich zur Unterstützung der überlagerten Bewegung verwendet werden kann. Hierbei ist die gesamte Belichtertrommel 2 mit Bewegungselementen 11 verbunden, welche vom Ansteuerungsorgan 6 so angesteuert werden, dass eine vorzugsweise periodische Bewegung der Belichtertrommel 2 und damit auch der Druckplatte 3 in Vorschubsrichtung 10, hier dargestellt durch Modulationsrichtung 12, erzeugt wird. Auch hierbei können kleine Auslenkungen der Belichtertrommel 2 im Kilohertzbereich realisiert werden.

Außer periodischen Auslenkungen von Träger 8 und/oder Belichtungstrommel 2 können auch zufällige Formen für die relative Bewegung zwischen Druckplatte 3 und Träger 8, d. h. den Modulen 7 erreicht werden, die dann beispielsweise mit jeder Umdrehung der Belichtertrommel wiederholt werden.

Durch diese Überlagerung der Modulationsbewegung von Belichtertrommel 2 und/oder Träger 8 können erfolgreich Moirées zumindest verringert werden. Dieses Verfahren soll dabei nicht alleine auf Druckplattenbelichter beschränkt werden, sondern eignet sich zur Anwendung auf alle Drucksysteme in denen Arrays verwendet werden, wie z. B. Inkjet oder elektrofotographische Drucksysteme mit Belichtungszeilen aus Fotodioden. Es ist dabei nicht alleine auf die Belichtung auf einer Belichtertrommel beschränkt, sondern sie eignet sich auch direkt für den Druck auf einem Papierbogen oder auf einem kontinuierlich bewegten Band oder die Belichtung eines bewegten Bandes oder einer entsprechenden Belichtertrommel. Weiterhin ist es zu beachten, dass die Daten gemäß den Bilddaten aus der Rasterbitmap entsprechend der Modulation der einzelnen Module 7 oder des gesamten Trägers 8 zeitverzögert ausgelesen werden müssen.

### Bezugszeichenliste

- 1: Plattenbelichter
- 2: Belichtertrommel
- 3: Druckplatte
- 4: Vorschubspindel
- 5: Vorschubsmotor
- 6: Ansteuerungsorgan
- 7: Lasermodule
- 8: Träger
- 9: Laserstrahlen
- 10: Vorschubsrichtung
- 11: Bewegungselement
- 12: Modulationsrichtung
- 13: RIP
- 14: Speichermittel

- 100: Raster
- 101: Pixel
- 102: Abstand
- 103: überlagerte Modulation

## Patentansprüche

1. Verfahren zum Bebildern eines Substrates mittels einer Mehrzahl von Bebilderungselementen, wobei die Bebilderungselemente im Wesentlichen in periodischen Abständen zu einander bereitgestellt werden und Bebilderungsemissionen auf die Oberfläche des Substrates in Abhängigkeit von Bilddaten emittieren und die Bebilderungsemissionen ein Rastermuster mit Rasterfrequenz auf dem Substrat ergeben,
**dadurch gekennzeichnet, dass**
die Rasterfrequenz mit einer höheren Ortsfrequenz überlagert wird.

2. Verfahren nach Anspruch 1,
**dadurch gekennzeichnet, dass**
die Größe der Ortsfrequenz stochastisch moduliert wird.

3. Verfahren nach Anspruch 1,
**dadurch gekennzeichnet, dass**
die Ortsfrequenz der Bebilderungsemissionen (9) auf dem Substrat (3) durch eine Relativbewegung von Substrat (3) und Bebilderungsemissionen (9) im Wesentlichen senkrecht zur Ausbreitungsrichtung der Bebilderungsemissionen (9) moduliert wird.

4. Verfahren nach Anspruch 3,
**dadurch gekennzeichnet, dass**
zur Modulation der Bebilderungsemissionen (9) Ablenkelemente in die Ausbreitungsrichtung der Bebilderungsemissionen (9) bereitgestellt und bewegt werden oder die Bebilderungsemissionen (9) entsprechend der vorgesehenen Überlagerung ablenken.

5. Verfahren nach Anspruch 1 und 3,
**dadurch gekennzeichnet, dass**
die Bebilderungselemente und das Substrat (3) zur Bebilderung des Substrat (3) mit einer ersten relativen Bewegung relativ zu einander bewegt werden und zur Modulation der relativen Positionen von Bebilderungsemissionen (9) und Substrat (3) zueinander der ersten Bewegung der Bebilderungselemente und des Substrat (3) eine zweite Bewegung (12) überlagert wird.

6. Verfahren nach Anspruch 5,
**dadurch gekennzeichnet, dass**
die Bebilderungselemente wenigstens teilweise auf einem gemeinsamen Träger (8) bereitgestellt werden, dieser Träger (8) relativ zum Substrat (3) in eine Vorschubsrichtung (10) bewegt wird und dieser Vorschubsbewegung (10) eine Modulationsbewegung im Wesentlichen in Richtung der Vorschubsbewegung (10) überlagert wird.

7. Verfahren nach Anspruch 5,
**dadurch gekennzeichnet, dass**
die Bebilderungselemente wenigstens teilweise auf einem gemeinsamen Träger (8) bereitgestellt werden, dieser Träger (8) relativ zum Substrat (3) in eine Vorschubsrichtung (10) bewegt wird, das Substrat (3) auf einer Basisfläche angeordnet ist und im Wesentlichen in Richtung der Vorschubsrichtung (10) des Trägers gemäß der zweiten Bewegung bewegt wird.

8. Verfahren nach wenigstens einem der vorigen Ansprüche,
**dadurch gekennzeichnet, dass**
es sich bei den Bebilderungselementen um eines aus der Menge Laserdiode, Laserquelle, Inkjetkopf, Inkjetdüse und Fotodiode handelt, dass es sich bei den Bebilderungsemissionen um eines aus der Menge Laserstrahl (9), Lichtstrahl, Inkjettropfen und Inkjetstrahl handelt, dass es sich bei dem Substrat um eines aus der Menge Bedruckstoff, Papier, Papierbahn, Papierbogen, Pappe, Folie, Film, Bebilderungstrommel und Druckplatte (3) handelt, und dass es sich bei den Ablenkelementen um eines aus der Menge optische Ablenkelemente, Linsen, Akustoopitscher Modulator und Kondensator handelt.

9. Vorrichtung zur Bebilderung eines Substrates mittels Bebilderungsemissionen, umfassend Bebilderungselemente zur Emission der Bebilderungsemissionen und erste Bewegungselemente zur relativen Bewegung der Bebilderungselemente und des Substrates zueinander,
**dadurch gekennzeichnet, dass**
weiter zweite Bewegungselemente (6, 11) zur Bewegung wenigstens eines Organes aus der Menge Bebilderungselemente, Substrat (3), Basisfläche zur Bereitstellung des Substrates (3), Träger (7, 8) zur Bereitstellung wenigstens einiger der Bebilderungselemente und Ablenkelemente zur Ablenkung der Bebilderungsemissionen (9) umfasst sind.

10. Vorrichtung nach Anspruch 9,
**dadurch gekennzeichnet, dass**
es sich bei dem Substrat um eine Druckplatte (3) handelt, die auf einer Trommel (2) oder in einer Belichtungsmulde bereitgestellt ist, die Bebilderungselemente Laserdioden sind, die wenigstens teilweise auf einem gemeinsamen Träger (7, 8) bereitgestellt sind, wobei die ersten Bewegungselemente in der Art einer Vorschubsspindel (4) mit einem Vorschubsmotor (5) bereitgestellt sind und die zweiten Bewegungselemente (6, 11) der Trommel (2) oder der Belichtungsmulde zur Bewegung der Trommel (2) oder der Belichtungsmulde gemäß eines zweiten Bewegungsprofils zugeordnet sind, sodass die Trommel (2) oder die Belichtungsmulde im Wesentlichen parallel zur Vorschubsrichtung (10) bewegt wird, sodass der Rasterfrequenz der Bebilderungsemissionen (9) auf der Druckplatte eine zweite größere Ortsfrequenz überlagert wird, wobei die Bebilderungsemissionen Laserstrahlen sind, die von den Laserdioden zur Bebilderung von Pixeln (101) auf der Druckplatte (3) emittiert werden.

11. Vorrichtung nach Anspruch 9,
**dadurch gekennzeichnet, dass**
es sich bei dem Substrat um eine Druckplatte (3) handelt, die auf einer Trommel (2) oder in einer Belichtungsmulde bereitgestellt ist, die Bebilderungselemente Laserdioden (9) sind, die Laserdioden Laserstrahlen als Bebilderungsemissionen zur Bebilderung der Druckplatte (3) emittieren und die Laserdioden wenigstens teilweise auf einem gemeinsamen Träger (7, 8) bereitgestellt sind, wobei die ersten Bewegungselemente in der Art einer Vorschubsspindel (4) mit einem Vorschubsmotor (5) bereitgestellt sind und die zweiten Bewegungselemente als Ansteuerungsorgan dem Vorschubsmotor so zugeordnet sind, dass dieser Vorschubsbewegung (10) des Trägers (7, 8) eine zweite Bewegung gemäß eines Bewegungsprofils so überlagert wird, sodass der Rasterfrequenz der belichteten Bildpunkten (101) auf der Druckplatte (3) eine zweite größere Ortsfrequenz überlagert wird.

12. Vorrichtung nach Anspruch 9,
**dadurch gekennzeichnet, dass**
es sich bei den Bebilderungselementen um eines aus der Menge Laserdiode, Laserquelle, Inkjetkopf, Inkjetdüse und Fotodiode handelt, dass es sich bei den Bebilderungsemissionen um eines aus der Menge Laserstrahl (9), Lichtstrahl, Inkjettropfen und Inkjetstrahl handelt, dass es sich bei dem Substrat um eines aus der Menge Bedruckstoff, Papier, Papierbahn, Papierbogen, Pappe, Folie, Film, Bebilderungstrommel und Druckplatte (3) handelt, und dass es sich bei den Ablenkelementen um eines aus der Menge optische Ablenkelemente, Linsen, Akustoopitscher Modulator und Kondensator handelt.
